# EUROPEAN PATENT APPLICATION

(11) **EP 2 862 955 A1**
(43) Date of publication of application: **22.04.2015**
(21) Application number: 14188154.0
(22) Date of filing: 08.10.2014
(51) Int. Cl.: C23C 16/02, C23C 16/56, C23C 28/04, C23C 16/26

(54) **Method and apparatus of growing metal-free and low stress thick film of diamond-like carbon**

(30) Priority: 15.10.2013 US 201361961445 P; 19.09.2014 US 201414490692
(71) Applicant: Nano And Advanced Materials Institute Limited, Kowloon, Hong Kong (CN)
(72) Inventor: Wang, Zhonghui Alex, Kowloon Hong Kong (CN)
(74) Representative: Modiano, Micaela Nadia

(57) **Abstract**

The presently claimed invention provides a metal-free and low stress thick film of diamond-like carbon (DLC). The diamond-like carbon layer of the present invention has a wide range of applications such as automotive coating, hydrophobic-hydrophilic tuning, solar photovoltaic, decorative coating, protective coating and bio-compatible coating. The presently claimed invention further provides a method and an apparatus to grow a metal-free and low stress thick film of diamond-like carbon by performing deposition and plasma etching to stack more than one diamond-like carbon layers together in the same chamber.

## Description

### Cross Reference to Related Application:

The present application claims priority from US provisional patent application serial number 61/961,445 filed October 15, 2013 and US non-provisional patent application serial number 14/490,692 filed September 19, 2014, and the disclosure of which is incorporated herein by reference.

### Field of the Invention:

The present invention relates to a carbon material, and particularly relates to diamond-like carbons (DLC) and diamond-like carbon films. More particularly, the present invention relates to metal-free and low stress thick film of diamond-like carbons. The present invention also relates to a method and apparatus for forming the metal-free and low stress thick film of diamond-like carbons.

### Background:

Diamond-like carbon films have a wide range of applications owing to their high hardness, wear resistance and low friction. However, presently available diamond-like carbon films present a number of technical challenges which constrain their applications, for example:
(1) High stress limits the maximum thickness a diamond-like carbon film can be grown;
(2) Fluorinated diamond-like carbon (F-DLC) has the hardness behavior which is comparable to that of diamond-like carbon but high stress;
(3) Growth rate of diamond-like carbon is relatively slow; and
(4) Metal-containing diamond-like carbon reduces the performance of low friction of diamond-like carbon.

To tackle some of the above challenges, various attempts have been made but no significant progress has ever been attained and such attempts include, for example, incorporating fluorine into diamond-like carbon films. In case of doping different metal ions into the carbon complex, the resulting diamond-like carbon films will have high friction which is undesirable.

### Summary of the Invention:

The present invention reduces stress and enhances hardness in diamond-like carbon films which can be used for applications, for example, automotive coating, hydrophobic-hydrophilic tuning, solar photovoltaic, decorative coating, protective coating and bio-compatible coating.

An object of the present invention is to produce a diamond-like carbon film stack with a sufficiently high thickness efficiently. A further object of the present invention is to overcome the constraint of saturating growth rate of depositing a diamond-like carbon layer.

One embodiment of the present invention is a metal-free fluorinated diamond-like carbon film stack. The said metal-free fluorinated diamond-like carbon film stack can be formed by repeated deposition with etching of surface prior to the repeated deposition. The said metal-free fluorinated diamond-like carbon has a reduced stress, an enhanced hardness and a thickness as desired.

Another embodiment of the present invention is a method of producing a metal-free fluorinated diamond-like carbon film stack. The said method comprises deposition and etching of diamond-like carbon layers. The words "layer" and "film" are used interchangeably hereinafter. The said method provides a high growth rate and can be implemented efficiently with the apparatus disclosed in the present invention. To prepare the surface for deposition of a new diamond-like carbon layer, etching is done on the existing diamond-like carbon layer prior to deposition in the same chamber without breaking the vacuum condition.

One aspect of the present invention is to reduce the stress in a diamond-like carbon coating by providing a diamond-like carbon film stack.

Another aspect of the present invention is to grow a thick diamond-like carbon film stack.

The other aspect of the present invention is to provide an apparatus and a method to produce a metal-free fluorinated diamond-like carbon film stack with a high growth rate. The diamond-like carbon growth mechanism has a lot to do with the behavior of the incoming hydrogen H and H-passivated diamond-like carbon surface. Modified surface of H-passivated diamond-like carbon will modulate the growth rate of diamond-like carbon film and hence the stress behavior of the resulting film.

The present invention relates to a mechanism of growing a diamond-like carbon film on substrates.

The major uniqueness of the present invention lies in several aspects:
(1) the novel idea of deposition and etching in separate but sequential steps instead of putting all the gases in the same deposition step or in two different chambers;
(2) the new apparatus is capable of accommodating both plasma-enhanced chemical vapor deposition (PECVD) and etching in the same chamber with flexibilities;
(3) fluorine-attenuated layer to reduce the stress while maintaining the basic property of hydrogenated diamond-like carbon.

Silicon materials such as Si, SiO₂ and Si₃N₄ are etched in fluorine chemistries such as SiF₂ and SiF₄ volatile species or fluorocarbon gases CₓH_{y} or aldehydes CₓH_{y}O_{z}. A plasma etching system is in the process of setting up to etch Si and SiO₂ with fluorine chemistry and if we put diamond-like carbon substrate in the etcher, the F* neutrals will attack both H- and C- in the diamond-like carbon in which case we can modify the diamond-like carbon surface through F neutral interaction.

The present invention provides a diamond-like carbon film stack, comprising a plurality of layers of metal-free diamond-like carbon stacking together; and a fluorine-attenuate surface on at least a first layer of metal-free diamond-like carbon to which a second layer of metal-free diamond-like carbon is deposited. The fluorine-attenuate surface of such a diamond-like carbon film stack is formed by etching said first layer of metal-free diamond-like carbon before deposition of said second layer of metal-free diamond-like carbon.

The present invention further provides a method of forming a diamond-like carbon film stack, comprising: depositing a first diamond-like carbon layer; etching the first diamond-like carbon layer to form a fluorine-attenuate surface on the first diamond-like carbon layer; and depositing a further diamond-like carbon layer on the fluorine-attenuate surface of the first diamond-like carbon layer to form a stack of diamond-like carbon layers. In an embodiment, the depositing uses one or more hydrocarbon gases. The etching and the depositing are performed in one single chamber without breaking vacuum condition.

Such a method of forming a diamond-like carbon film stack, further comprising: determining the thickness of the stack of diamond-like carbon layers.

Such a method of forming a diamond-like carbon film stack, further comprising: repeating for one or more times of etching of the top of the stack of diamond-like carbon layers and of depositing a new diamond-like carbon layer on the top of the stack of diamond-like carbon layers which has been etched until the thickness of the stack of diamond-like carbon layers reaches a desired value. The present invention further provides a diamond-like carbon film stack manufactured by the aforesaid method.

The method of forming a diamond-like carbon film stack, further comprising: etching a substrate on which the first diamond-like carbon layer is deposited. In an embodiment, the etching uses one or more fluorocarbon gases.

In an embodiment, different process parameters such as pressure and temperature are used for etching or depositing when repeating etching and depositing so that etching will be performed with a first set of process parameters and depositing will be performed with a second set of process parameters wherein the first set of process parameters are different from the second set of process parameters.

The present invention further provides an apparatus for forming a diamond-like carbon film stack, comprising: a power supply for plasma generation capable of providing an output selected from the group consisting of a radiofrequency output, a pulsed output and an output combining a radiofrequency output with DC; a chamber with supply of one or more gases for etching and depositing; and an end-point detection device for detecting a fluorine-terminated surface. In an embodiment, each of said one or more gases has a gas flow controlled by variable waveforms.

Such an apparatus further comprises: a plurality of ports for supplying said one or more gases from a plurality of locations of said chamber.

Such an apparatus of claim 11, further comprising: a substrate holder with a heated chuck for holding one or more substrates on which diamond-like carbon film stacks to be formed.

In another embodiment, the chamber in such an apparatus generates a pulsed DC excited plasma and a radio-frequency excited plasma. And the radio-frequency excited plasma operates at a frequency ranging from 13.56MHz to 60GHz.

In another embodiment, the chamber of such an apparatus has a plasma density control.

In another embodiment, the chamber of such an apparatus has a plasma source selected from the group consisting of inductively coupled plasma and electron cyclotron resonance.

In another embodiment, the chamber of such an apparatus supplies a tunable bias voltage to a substrate.

In another embodiment, the end-point detection device of such an apparatus uses ellipsometry for monitoring the thickness of the diamond-like carbon film stack.

### Brief Description of the Drawings:

Embodiments of the present invention will now be described solely by way of example in more detail hereinafter with reference to the accompanying drawings, in which:
FIG. **1A** is a graph showing change of growth rate of a diamond-like carbon film over time in a process of growing a diamond-like carbon film by continuous deposition without being intervened by any etching during deposition.
FIG. **1B** is a graph showing change of thickness of a diamond-like carbon film over time in a process of growing a diamond-like carbon film by continuous deposition without being intervened by any etching during deposition.
FIG. **1C** is a graph showing change of growth rate of a diamond-like carbon film over time in a process of growing a diamond-like carbon film by repeated depositions with etching as an intermediate step between every two deposition steps according to an embodiment of the present invention.
FIG. **1D** is a graph showing change of thickness of a diamond-like carbon film over time in a process of growing a diamond-like carbon film by repeated depositions with etching as an intermediate step between every two deposition steps according to an embodiment of the present invention.
FIGS. **2A - 2F** are schematic diagrams depicting a series of steps of how etching and deposition is implemented in one embodiment of the present invention.
FIG. **3** is a flow chart illustrating the steps of a method of growing diamond-like carbon using etching and deposition according to one embodiment of the present invention.
FIG. **4** is a schematic diagram depicting an apparatus for deposition and etching according to one embodiment of the present invention.

### Detailed Description of Preferred Embodiments:

In the following description, a method of etching and deposition to grow a diamond-like carbon film, and an apparatus for etching and deposition to grow a diamond-like carbon film are set forth as preferred examples. It will be apparent to those skilled in the art that modifications, including additions and/or substitutions, may be made without departing from the scope and spirit of the invention. Specific details may be omitted so as not to obscure the invention; however, the disclosure is written to enable one skilled in the art to practice the teachings herein without undue experimentation.

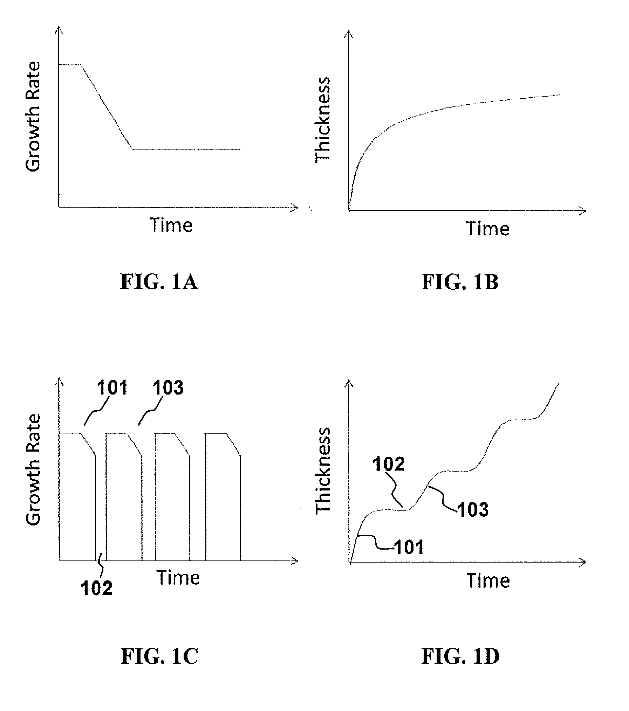

For growing a diamond-like carbon film, deposition of diamond-like carbon on a substrate is completed in one continuous step. FIG. **1A** is a graph showing change of growth rate of a diamond-like carbon film over time in a process of growing a diamond-like carbon film by one single continuous deposition without any etching of the surface on which a layer of diamond-like carbon is deposited. As shown by the graph in FIG. **1A****,** the growth rate of a diamond-like carbon film during deposition will drop over time, having a peak level at the beginning of deposition and subsequently remaining at a low level throughout the rest of the deposition.

As shown by the graph in FIG. **1B****,** the thickness of a diamond-like carbon film will increase at a faster rate at the beginning of deposition. Subsequently, the rate of increase in the thickness of the diamond-like carbon film will drop over time and the thickness of the diamond-like carbon film will become saturated with less and less increase after depositing the diamond-like carbon on the substrate for a certain period of time continuously.

Instead of depositing diamond-like carbon on a substrate in one single continuous step only, the present invention deposits diamond-like carbon on a substrate for a number of times repeatedly to form a stack of diamond-like carbon films. Therefore, deposition of diamond-like carbon film is carried out in an on and off manner.

FIG. **1C** is a graph showing change of growth rate of a diamond-like carbon film over time in a process of growing a diamond-like carbon film by repeated depositions with etching of the surface of the diamond-like carbon before every deposition according to an embodiment of the present invention. As shown in FIG. **1C****,** the first deposition step **101** starts with a high growth rate of diamond-like carbon film. Deposition will continue until the growth rate of diamond-like carbon film starts to decline. Therefore, when the growth rate of diamond-like carbon film drops to certain level or before it drops, the first deposition step **101** will be stopped and etching of the surface of the diamond-like carbon film will start. The growth rate for depositing diamond-like carbon film will drop after deposition for several seconds to hundreds of seconds depending on chamber geometry and it will drop to a level depending on the diffusion barrier length during deposition. The etching step **102** will last for a certain period of time until the surface of the diamond-like carbon film has been sufficiently modified for next deposition. The etching step **102** lasts for a period of time ranging from several seconds to hundreds of seconds depending chamber geometry and etching gas mixtures.

Subsequent to the etching step **102,** deposition of diamond-like carbon film on a substrate will start again with a high growth rate of a diamond-like carbon film in the second deposition step **103.** This repeated deposition of diamond-like carbon film will stop when the growth rate of the diamond starts to decline or after a certain period of time. Subsequently, the diamond-like carbon film will be processed by etching again for a certain period of time.

In every deposition step for forming a diamond-like carbon film stack, it takes around the same length of time for depositing a layer of diamond-like carbon to reach a desired thickness for each layer. However, the built-up stress with thick layer will eventually affect the length of time for each deposition.

Similarly, in case of etching, the length of time for each etching step will remain almost the same. The built-up stress with thick layer will eventually affect length of time for etching in the same way the length of time for deposition is affected.

The process of deposition followed by etching will be repeated for a number of times until the thickness of the diamond-like carbon film reaches a certain desirable level. The number of times for repeated deposition with prior etching depends on the desirable thickness of the diamond-like carbon film stack to be deposited and the chamber volume and the pumping speed of the pumps connected to the chamber where the deposition and the etching are performed.

In the process of repeated deposition and etching, the thickness of the diamond-like carbon film will increase in a way as shown in FIG. **1D****.** The thickness will increase when the first deposition step **101** takes place. The rate of increase in the thickness is higher at the beginning of the first deposition step and gradually drops over time, hence the increase in thickness of the diamond-like carbon film will get slower and slower. After depositing diamond-like carbon film on a substrate for a certain period of time in the first deposition step **101,** the thickness of the diamond-like carbon film will stop increasing and remain more or less the same at a later stage of deposition.

Subsequent to the first deposition step **101,** etching of diamond-like carbon film will start and the thickness of the diamond-like carbon will remain roughly the same throughout the etching step **102**.

After etching for a certain period of time, the etching step **102** will end and the second deposition step **103** will start. At the beginning of the second deposition step **103,** the thickness of the diamond-like carbon film increases faster and then the rate of increase in the thickness of the diamond-like carbon film will gradually drop. Towards the end of the second deposition step **103,** the thickness of the diamond-like carbon film will stop increasing and remain roughly the same.

In a process of repeated deposition followed by etching, the thickness of the diamond-like carbon film can increase to the desired level by accumulating the thickness allowed by each step of deposition.

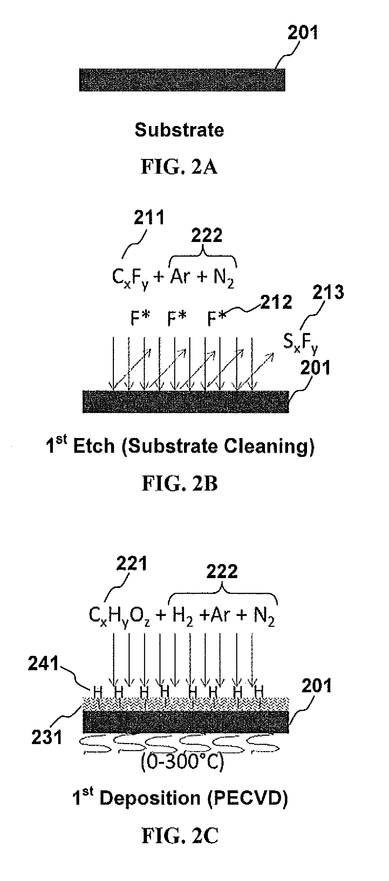

FIGS. **2A - 2F** are schematic diagrams depicting a series of steps of how etching and deposition is implemented in one embodiment of the present invention.

FIG. **2A** shows a substrate **201** on which a diamond-like carbon film is to be grow on. As an example, the substrate **201** is illustrated as a flat rectangular sheet. Nevertheless, the present invention allows a diamond-like carbon film to be grown on a substrate **201** of any shape, for example, cone shape or with any surface including rugged or flat or any other profile. In a preferred embodiment, a flat surface is used for growing a diamond-like carbon layer thereon for uniformity control.

Substrate **201** is made from materials such as, but not limited to, Si, SiO₂, other silicon materials, or stainless steel coupon. Both organic and inorganic substrates are suitable for diamond-like carbon layer to grow on. The substrate **201** is placed inside a chamber where a diamond-like carbon film is grown on the substrate **201**. The said chamber provides an airtight environment for processing the substrate **201** to grow a diamond-like carbon film.

In an embodiment, one or more additional adhesion layers are coated on the substrate **201** in order to facilitate the growth of diamond-like carbon layer on different substrate materials. The adhesion layer of the substrate **201** is made from materials such as Cr, Ti and W or other metals.

In a preferred embodiment, the chamber in use allows both plasma etching and PECVD deposition to take place inside it so that both plasma etching and PECVD deposition will be performed in the same chamber. The chamber is a dual frequency chamber of radiofrequency (RF) biased (13.56MHz up to 2.4GHz). The chamber has a plasma density control for the source and the possible source for the chamber includes inductively coupled plasma (ICP) or electron cyclotron resonance (ECR). Various waveforms are used to control the gas flow into chamber, such as on and off (square wave), or gradually on and off (sinusoidal wave). Power supply for plasma etching and plasma-enhanced chemical vapour deposition (PECVD) can provide RF, alternate current (AC) and direct current (DC), or pulse output to bias the sample and enhance the plasma density.

In a preferred embodiment, RF with a range of up to 1500W is used as the power supply.

In another preferred embodiment, DC with a range up to 10000W is used as the power supply.

In a further preferred embodiment, pulse current with a frequency range up to 500kHz, power ratio up to 10kW and a duty cycle up to 50% reverse time with reverse time of 0.5 to 10µsec is used.

FIG. **2B** shows a plasma etching step for cleaning the substrate **201.** In one preferred embodiment, the substrate **201** is cleaned with etching gases **211** containing fluorine-containing etch chemistries before growing any diamond-like carbon film on the substrate **201.** Fluorine-containing etch chemistries such as CₓF_{y}O_{z}, CₓF_{y} and SiFₓ (e.g. SiF₂ and SiF₄) volatile species are used for etching. During the cleaning of the substrate **201,** the said chamber is supplied with one or more etching gases **211** such as fluorocarbon gases (e.g. CHF₃, CF₄, C₃F₈) or fluorocarbon containing gases such as a mixture of CₓF_{y} with other facilitating gases **222** such as Ar, N₂ and others. One or more kinds of SₓF_{y} **213** are released during plasma etching of the substrate **201.** Sputtering of Ar on the adhesion layer of the substrate **201** such as Cr, Ti and W or other metals is performed for substrate cleaning.

In a preferred embodiment, plasma etching of the substrate **201** is performed at a temperature range of -40°C to 400°C and a pressure range of 100 Torr to 10⁻⁵ Torr with 5%-100% of fluorine-containing gas.

FIG. **2C** shows a step of deposition of diamond-like carbon material on top of the substrate **201.** Subsequent to substrate cleaning by plasma etching, first deposition of diamond-like carbon will be performed on the substrate **201**. In this first deposition step, a layer of diamond-like carbon **231** is deposited by plasma-enhanced chemical vapor deposition (PECVD) on the substrate **201** which has been cleaned with etching gases **211** such as fluorine-containing etch chemistries. A diamond-like carbon layer **231** is deposited on the substrate **201** using deposition gases **221** such as CₓH_{y} or CₓH_{y}O_{z} together with one or more various facilitating gases **222** such as H₂, Ar and N₂. The combination and the concentration of each facilitating gases **222** vary with the numbers of carbon atoms x and number of hydrogen atoms y in each of the deposition gas molecules **221.** The incoming H will form a H-passivated diamond-like carbon surface **241** on the diamond-like carbon layer **231.** The H₂ is controlled according to the numbers of hydrogen atoms in the CₓH_{y} or CₓH_{y}O_{z} group.

In a preferred embodiment, the deposition gas **221** is CH₂O.

In a preferred embodiment, the substrate **201** is kept at a temperature ranging from 0°C to 300°C during the first deposition.

In a preferred embodiment, deposition of diamond-like carbon film is performed at a temperature range of -40°C to 400°C and a pressure range of 100 Torr to 10⁻⁵ Torr with 5%-100% of carbon-containing gas or vapour.

During deposition of diamond-like carbon layer, the gas species for deposition are hydrogen-rich so that hydrogen can easily penetrate into 5% to 100% of the diamond-like carbon layer thickness. The removal of hydrogen depends on the critical thickness of hydrogen-containing diamond-like carbon layer and the penetration depth by fluorine, which is controlled by deposition and etching time.

After deposition for a certain period of time, a H-passivated diamond-like carbon surface **241** will be formed on top of the newly deposited diamond-like carbon layer **231.** The H-passivated diamond-like carbon surface **241** is thin with a thickness of around several nm up to less than 100nm.

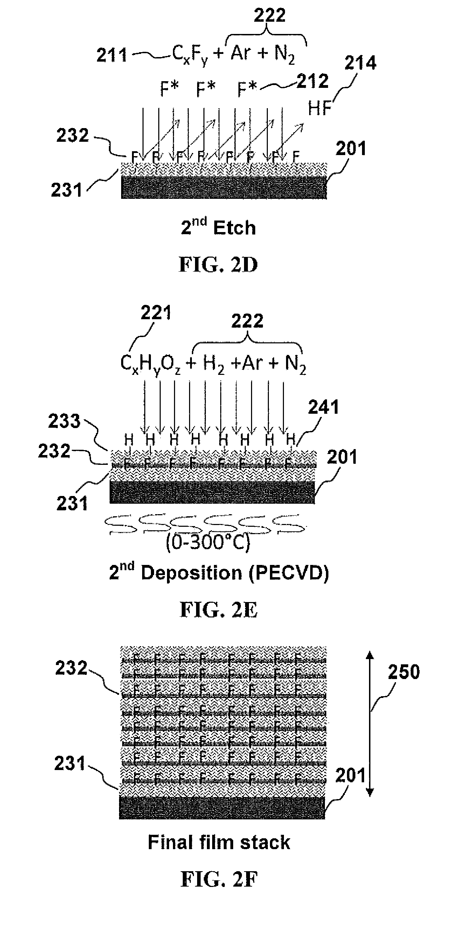

FIG. **2D** shows a step of etching of diamond-like carbon film with etching gases **211.** After first deposition of a diamond-like carbon layer **231**, the diamond-like carbon layer is etched with etching gases **211** such as fluorine-containing etch chemistries or a mixture of gases containing etching gases **211** and other facilitating gases **222.** The etching step is performed between any two deposition steps and acts as an intermediate step between a first deposition and a second deposition. During etching, the chamber is supplied with various etching gases **211** including fluorocarbon gases such as CHF₃, CF₄, C₃F₈ and other facilitating gases **222** such Ar and N₂. The etching of diamond-like carbon layer **231** uses CₓF_{y} or CₓF_{y} containing gases such as a mixture of CₓF_{y} with Ar, N₂ and H₂. The fluorine neutrals **212** from the etching gases **211** such as fluorine-containing etch chemistries attack both hydrogen and carbon in the diamond-like carbon layer **231** so that the etching modifies the surface of the diamond-like carbon layer **231.** During etching, a fluorine-attenuate layer **232** is formed on the surface of the diamond-like carbon layer **231** after fluorine neutrals attacks the hydrogen in the diamond-like carbon layer **231** to release HF **214**.

Fluorine penetrates into the diamond-like carbon layer **231** and selectively removes the hydrogen in the diamond-like carbon layer **231.** In the meantime, the penetrating fluorine radicals also incorporate into the diamond-like carbon layer **231.**

In a preferred embodiment, etching of diamond-like carbon film is performed at a temperature range of -40°C to 400°C and a pressure range of 100 Torr to 10⁻⁵ Torr with 5%-100% of fluorine-containing gas.

In another embodiment, etching of diamond-like carbon film may adopt typical semiconductor etching process parameters.

FIG. **2E** shows a step of deposition of diamond-like carbon material on top of the substrate **201.** Subsequent to etching, second deposition of diamond-like carbon will be performed on the substrate **201.** In this second deposition step, a layer of diamond-like carbon **233** is deposited by plasma-enhanced chemical vapor deposition (PECVD) on the fluorine-attenuate surface **232** of the diamond-like carbon layer **231.** A diamond-like carbon layer **231** is deposited on the top of the surface of the diamond-like carbon layer **231** using deposition gases **221** such as CₓH_{y}O_{z} and CₓH_{y}, or using deposition gases **221** together with one or more various facilitating gases **222** such as Ar, N₂ and H₂.

In a preferred embodiment, the deposition gases **221** in use is CH₂O. Depending on the number of hydrogen atoms x and the number of hydrogen atoms y in deposition gas **221** molecules of CₓH_{y} and CₓH_{y}O_{z}, the concentration, ratio, pressure of the various facilitating gases **222** are determined and used accordingly in one embodiment.

FIG. **2F** shows the film stack having the desired thickness. The process of deposition followed by etching will be repeated to deposit a plurality of diamond-like carbon layers **231** on top of one another and form a final film stack with a desired thickness **250** as shown in FIG. **2F****.** Every time after the deposition of a diamond-like carbon layer **231** is completed, etching will be performed on the newly deposited diamond-like carbon layer **231** before depositing another new layer of diamond-like carbon. The cycle of first deposition and then etching and then second deposition so on and so forth will continue until the thickness of the final film stack reaches the desired level **250**. For example, the desired thickness **250** is around several hundreds of microns. Particularly in an embodiment, the desired thickness of a diamond-like carbon film stack **250** is around 400 µm.

In a preferred embodiment, the diamond-like carbon layers **231** being deposited to form a diamond-like carbon film stack is a metal-free diamond-like carbon.

In another preferred embodiment, the diamond-like carbon layers **231** being deposited to form a diamond-like carbon film stack is a metal-free hydrogenated diamond-like carbon.

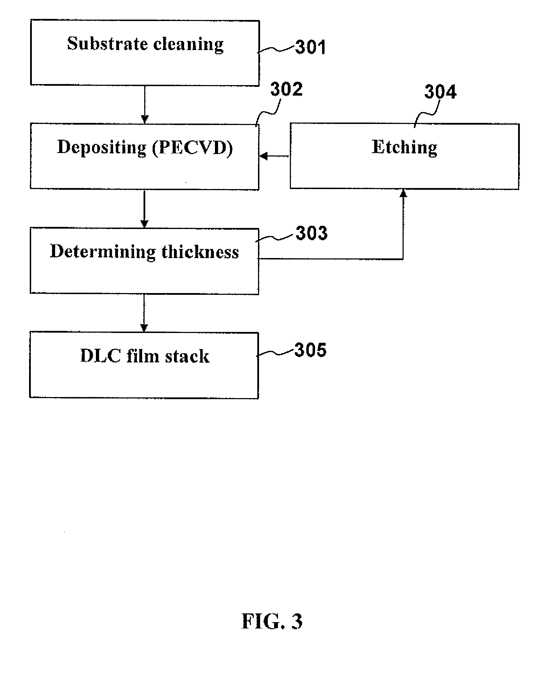

FIG. **3** is a flow chart illustrating the steps of a method of growing diamond-like carbon film using etching and deposition according to one embodiment of the present invention.

Firstly, there will be a substrate cleaning step **301** by etching a substrate using CₓF_{y} or CₓF_{y} containing gases in a plasma environment. The CₓF_{y} containing gases is a mixture of CₓF_{y}, Ar, N₂ and other gases.

Subsequent to cleaning the substrate **301,** a layer of diamond-like carbon is deposited on the substrate in a depositing step **302.** In a preferred embodiment, the depositing step **302** is a plasma-enhanced chemical vapour deposition (PECVD). A diamond-like carbon layer is deposited on a substrate using CₓH_{y} or CₓH_{y} containing gases. The CₓH_{y} containing gases is a mixture of CₓH_{y}, H₂ and Ar.

After depositing a diamond-like carbon layer in a depositing step **302,** the surface of the diamond-like carbon layer is then etched by CₓF_{y}O_{z}, CₓF_{y} or CₓF_{y} containing gases in an etching step **304** to modify the surface of the diamond-like carbon layer and form a fluorine-attenuate surface on the diamond-like carbon layer.

Being attacked by neutral fluorine atoms from fluorine-containing etch chemistries such as CₓF_{y} containing gases, the hydrogen-containing diamond-like carbon layer is modified and releases HF during the etching step **304.**

Subsequent to etching **304,** a further diamond-like carbon layer is deposited on the etched surface of the diamond-like carbon layer by repeating the depositing step **302.** The depositing step **302** is repeated for one or more times to form a stack of diamond-like carbon layers. Every time before a new diamond-like carbon layer is deposited **302** on the top of the stack of diamond-like carbon layers, the top of the stack of more than one diamond-like carbon layers is cleaned in an etching step **304.** In a preferred embodiment, the etching step **304** is a plasma etching.

Before etching **304,** the thickness of the stack of diamond-like carbon layers may be determined in a thickness determining step **303.** If the thickness of the stack of diamond-like carbon layers reaches a desired value, no further etching or depositing of diamond-like carbon layer is necessary and the stack of diamond-like carbon layers with the desired thickness will be the DLC film stack **305.**

If the thickness of the stack of diamond-like carbon layers has not reached a desired value, the etching **304** will be repeated with a set of parameters such as etching duration independent of any earlier depositing processing. This set of parameters for etching **304** may remain the same as or become different from the parameters being used before. After etching **304,** depositing **302** will be repeated with a set of parameters such as deposition duration independently determined to suit the deposition need of each time.

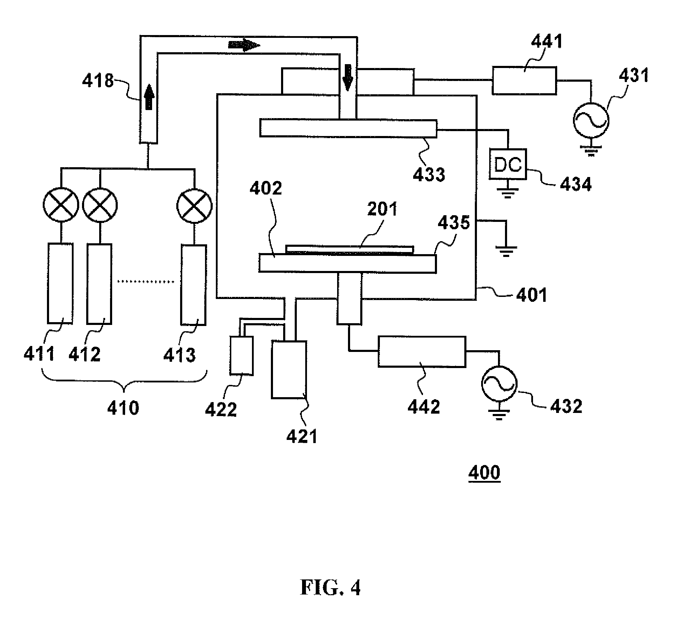

For PECVD and plasma etching, the depositing step **302** and the etching step **304** are performed in a chamber where plasma is generated. The apparatus which provides such a chamber is described in FIG. **4****.**

FIG. **4** is a schematic diagram depicting an apparatus **400** for depositing and etching diamond-like carbon layers according to one embodiment of the present invention.

The apparatus **400** has a chamber **401.** The body of the chamber **401** is earthed. A first electrode **433** is connected to a first AC power supply **431** through a first matchbox **441.** A second electrode **435** is connected to a second AC power supply **432** through a second matchbox **442.** The first AC power supply **431** and the second AC power supply **432** operate with their respective matchbox to excite the particles in the chamber **401** and generate radio-frequency excited plasma in the chamber **401.**

In a preferred embodiment, the radio-frequency excited plasma operates at a dual frequency ranging from 13.56MHz up to 2.4GHz.

The first electrode **433** is connected to a DC power supply **434.** The DC power supply **434** generates the pulsed DC excited plasma.

These first AC power supply **431** and second AC power supply **432** together with the DC power supply **434** act as a power supply for plasma generation and give various inputs such as a radiofrequency output, a pulsed output and an output combining a radiofrequency output with DC.

The chamber **401** has a plasma density control (not shown) for the plasma source and the plasma source for the chamber **401** includes inductively coupled plasma (ICP) or electron cyclotron resonance (ECR).

The chamber **401** provides a single chamber for both etching and deposition to take place therein. Different plasma conditions are applied to each etching cycle and deposition cycle respectively. Therefore, the chamber **401** provides a tunable bias for deposition and etching.

One or more pipes or channels **418** connect one or more gas supplies **410** to the chamber **401.** Gas supplies **410** containing fluorocarbon gases CₓF_{y} **411,** aldehyde gases CₓH_{y}O_{z} **412,** and other facilitating gases **413.** Other facilitating gases **413** include, for example, argon Ar, hydrogen H₂ and nitrogen N₂.

The channels **418** are connected to various ports (not shown) of the chamber **401.** Various ports are located at the top of the chamber **401,** at the bottom of the chamber **401** or on the sides of the chamber **401.** Through these ports, various gases are supplied to the chamber **401** by various gas introduction and pumping combinations.

To control processing parameters such as pressure or gas concentration or gas flow rate in the chamber **401,** one or more mechanical pumps **422** or turbo molecular pumps **421** are used by the chamber **401** to pump gases in and out of the chamber **401.**

Furthermore, gas supplies **410** are controlled by a gas flow control (not shown). The gas flow control controls the gas flow in accordance with different waveforms, for example, following a square function to turn on and off, or following a sinusoidal function to gradually turn on and off.

The substrate **201** is placed on a substrate holder **402.** The substrate holder **402** is equipped with a chuck. The chuck is either lamp-heated or resistively heated. The substrate **201** will be heated on the substrate holder **402** by the chuck. In a preferred embodiment, the substrate **201** is maintained at a temperature range from 0°C to 300°C by the chuck during processing.

The chamber **401** has an end-point detection device (not shown) which performs thickness measurement and determines when to stop etching. In addition, the thickness of the stack of diamond-like carbon layers is determined the end-point detection device and the end-point detection device determines when to stop deposition of any additional diamond-like carbon layer by measuring the thickness of the stack of diamond-like carbon layers. The end-point detection device makes use of various in-situ monitoring metrology such as ellipsometry and other optical non-destruction detection mechanisms and one example for such a device is an interferometer.

The foregoing description of the present invention has been provided for the purposes of illustration and description. It is not intended to be exhaustive or to limit the invention to the precise forms disclosed. Many modifications and variations will be apparent to the practitioner skilled in the art.

The embodiments were chosen and described in order to best explain the principles of the invention and its practical application, thereby enabling others skilled in the art to understand the invention for various embodiments and with various modifications that are suited to the particular use contemplated. It is intended that the scope of the invention be defined by the following claims and their equivalence.

## Claims

1. A method of forming a diamond-like carbon film stack, comprising:
depositing a first diamond-like carbon layer;
etching the first diamond-like carbon layer to form a fluorine-attenuate surface on the first diamond-like carbon layer; and
depositing a further diamond-like carbon layer on the fluorine-attenuate surface of the first diamond-like carbon layer to form a stack of diamond-like carbon layers.

2. The method of forming a diamond-like carbon film stack of claim 1, further comprising:
determining the thickness of the stack of diamond-like carbon layers.

3. The method of forming a diamond-like carbon film stack of claim 2, further comprising:
repeating for one or more times of etching of the top of the stack of diamond-like carbon layers and of depositing a new diamond-like carbon layer on the top of the stack of diamond-like carbon layers which has been etched until the thickness of the stack of diamond-like carbon layers reaches a desired value.

4. The method of forming a diamond-like carbon film stack of claim 1, further comprising:
etching a substrate on which the first diamond-like carbon layer is deposited.

5. The method of forming a diamond-like carbon film stack of claim 1, wherein:
said etching uses one or more fluorocarbon gases.

6. The method of forming a diamond-like carbon film stack of claim 1, wherein:
said depositing uses one or more hydrocarbon gases.

7. The method of forming a diamond-like carbon film stack of claim 1, wherein:
said hydrocarbon gas is CH₂O.

8. The method of forming a diamond-like carbon film stack of claim 3, wherein:
a first set of process parameters are used for etching;
a second set of process parameters are used for depositing; wherein the first set of process parameters are different from the second set of process parameters when repeating said etching and said depositing.

9. The method of forming a diamond-like carbon film stack of claim 1, wherein:
said etching and said depositing are performed in one single chamber without breaking vacuum condition.

10. A diamond-like carbon film stack manufactured by the method of claim 1.

11. An apparatus for forming a diamond-like carbon film stack by the method of claim 2, comprising:
a power supply for plasma generation capable of providing an output selected from the group consisting of a radiofrequency output, a pulsed output and an output combining a radiofrequency output with DC;
a chamber with supply of one or more gases for etching and depositing; and
an end-point detection device for detecting a fluorine-terminated surface.

12. The apparatus of claim 11, further comprising:
a plurality of ports for supplying said one or more gases from a plurality of locations of said chamber.

13. The apparatus of claim 11, wherein:
each of said one or more gases has a gas flow controlled by variable waveforms.

14. The apparatus of claim 11, wherein:
said chamber generates a pulsed DC excited plasma and a radio-frequency excited plasma.

15. The apparatus of claim 14, wherein:
said radio-frequency excited plasma operates at a frequency ranging from 13.56MHz to 60GHz.
